# EUROPEAN PATENT APPLICATION

(11) **EP 1 050 818 A1**
(43) Date of publication of application: **08.11.2000**
(21) Application number: 99410062.6
(22) Date of filing: 03.05.1999
(51) Int. Cl.: G06F 12/04, G06F 9/34, G11C 8/00

(54) **Computer memory access**

(71) Applicant: STMicroelectronics SA, 94250 Gentilly Cedex (FR)
(72) Inventor: Grossier, Nicolas, 38450 St.Georges-de-Commiers (FR); Dabbagh, Ahmed, 38120 Saint-Egrève (FR); Bernard, Bruno, 38130 Echirolles (FR); Rahaga, Tiana, 38920 Crolles (FR)
(74) Representative: Driver, Virginia Rozanne

(57) **Abstract**

A computer memory has at least two memory banks each having respective access circuitry and a memory capacity of half a word at each word address, the memory addressing circuitry providing an address to two memory banks simultaneously with adder circuitry to add to a word address for one of the banks a number equal to the number of bytes in a word thereby accessing two unaligned half words from respective memory banks.

## Description

The invention relates to apparatus and methods for accessing data in a memory. Known memories for use in computer systems including digital signal processing (DSP) systems may store data in bit sequences forming discrete words each word being addressable in order to access the word location. In this way a data word, commonly consisting of a plurality of bytes, may be read by a single read operation at a single word address. Similarly a word of data may be written into the memory by a single write operation at a single word address. Such systems have the advantage of reading or writing into the memory a plurality of bytes by a single addressing and accessing operation. The word length used in such a memory system may typically be a 32 bit word or a 16 bit word or may be longer by using a higher multiple of 8 bit bytes.

It is an object of the present invention to provide improved apparatus and methods for accessing an unaligned word in memory.

It will be understood that when data is stored in a memory in the form of data words, word boundaries are identified by a change in address. In the case of an unaligned word, a word of data is addressed by access to a half word boundary.

The invention provides a computer system comprising instruction supply circuitry, a plurality of parallel instruction execution pipelines, a read and write memory, a memory addressing circuitry for addressing said memory as a result of instruction execution in said pipelines, wherein said memory is arranged to hold data in addressable words each comprising a plurality of bytes forming two half words, said memory addressing circuitry being operable to provide successively a plurality of word addresses and said memory comprising two memory banks each having respective access circuitry for the same word addresses and a memory capacity of half a word at each word address, said memory addressing circuitry having address output circuitry to provide an address to both memory banks simultaneously and adder circuitry to add to a word address for one of the banks a number equal to the number of bytes in a word, the address output circuitry thereby being selectively operable to access in a single access cycle two unaligned half words from respective memory banks at adjacent word locations in the two memory banks.

Preferably said memory addressing circuitry is arranged to separate each word address into a first set of bits identifying a memory region provided by said two memory banks and a second set of bits identifying a memory address within said memory banks, said adder being arranged to receive said second set of bits and selectively add said number to said second set of bits.

Preferably said second set of bits comprise the least significant half of the bits of the memory address.

Preferably said one of said memory banks is connected to a multiplexer having two inputs, one input being an output from said adder and a second input being the address supplied to the other memory bank, whereby selective operation of the multiplexer permits access to an aligned word or an unaligned word in the two memory banks.

Preferably said memory addressing circuitry is operable to provide byte enable signals to indicate which bytes at each word address are to be accessed, and said access circuitry of each memory bank is arranged to receive said byte enable signals to access selected bytes at each word location addressed in the memory banks.

Timing circuitry is used to control access to each memory bank simultaneously in successive access cycles, said memory addressing circuitry being operable to access either aligned or unaligned words in the same access cycle.

The invention includes a method of accessing memory in a computer system having a memory arranged to hold data in addressable words each comprising a plurality of bytes forming two half words, said method comprising dividing the memory into two memory banks each having respective access circuitry for the same word addresses and a memory capacity of half a word at each word address, generating a single address for use in addressing both memory banks simultaneously, adding to said address a number equal to the number of bytes in a word to form an incremented address and selectively supplying said address to one memory bank and said incremented address to the other memory bank thereby to access in the same access cycle half words from respective memory banks forming an unaligned word.

Preferably said address comprises only the least significant bits of a full word address, said bits being sufficient to identify the memory region provided by said memory banks and said number is added only to said least significant bits.

Preferably byte enable signals are supplied to each memory bank to access selected bytes at each word location addressed in the memory bank.

An embodiment of the invention will now be described by way of example and with reference to the accompanying drawings in which:
Figure 1 is a block diagram of a computer system in accordance with the present invention,
Figure 2 shows in more detail part of the apparatus of Figure 1,
Figure 3 illustrates various bit configurations which may be used in accordance with the invention,
Figure 4 illustrates address bit control used in accordance with the invention, and
Figure 5 illustrates results of memory accessing used in accordance with the invention.

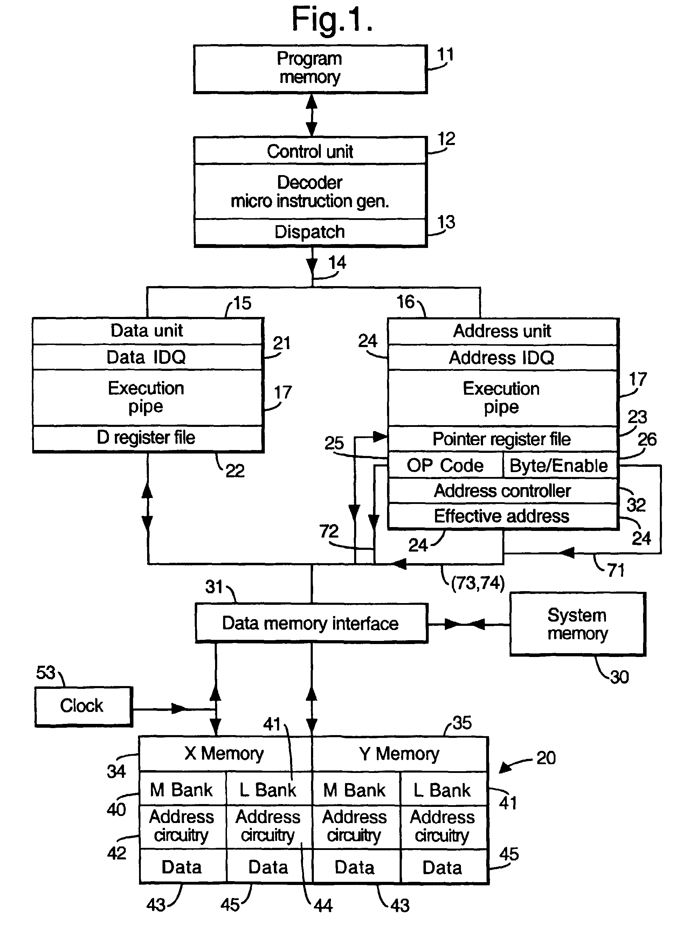

The particular example shown in Figure 1 illustrates a computer system used as a digital signal processor (DSP). Instructions are held in a program memory 11 and fetched by a control unit 12 which includes a decoder as well as a microinstruction generator. The microinstructions are output by a dispatch circuit 13 along line 14 to either a data unit 15 of an address unit 16 coupled in parallel. The data unit 15 and address unit 16 each include an execution pipeline 17 arranged to execute instructions in parallel using a data memory 20. The data unit 15 may itself include two parallel execution pipes receiving instructions from a data instruction queue 21 and accessing a common data register file 22. The address unit 16 may also include two parallel execution pipes accessing a common pointer register file 23 and receiving instructions from an instruction queue 24. Execution of instructions in the address unit will result in the generation of an effective address (EA) 24 for use in memory accessing as well as an OP code 25 and byte enable signals 26 for use in the memory accessing. The effective address is provided as an output of an address controller 32.

By arrangement of the data unit 15 and address unit 16 in parallel, the two units may simultaneously execute instructions thereby providing an access decoupled system providing improved efficiency in data manipulations involving the memory 20. The system may also incorporate an external system memory 30. Both memory 20 and the system memory 30 are coupled to a data memory interface 31. The effective address 24 generated by the address unit 16 may provide access to the system memory 30 or to the local memory 20. Access will be controlled by the memory interface 31.

In this particular case the local memory 20 consists of two parts. A first part is indicated as an X memory 34 and a second part consists of a Y memory 35. The X memory and Y memory are similarly constructed and each consists of an M bank 40 and an L bank 41. The M bank 40 has its own addressing circuitry 42 and a data storage region 43. Similarly the L bank has its own addressing circuitry 44 and its own data storage region 45.

Accesses to the X and Y memories 34 and 35 are controlled by timing signals from a clock 53 coupled to the memory interface 31 and the memory banks so that memory accesses are operated on clocked cycles.

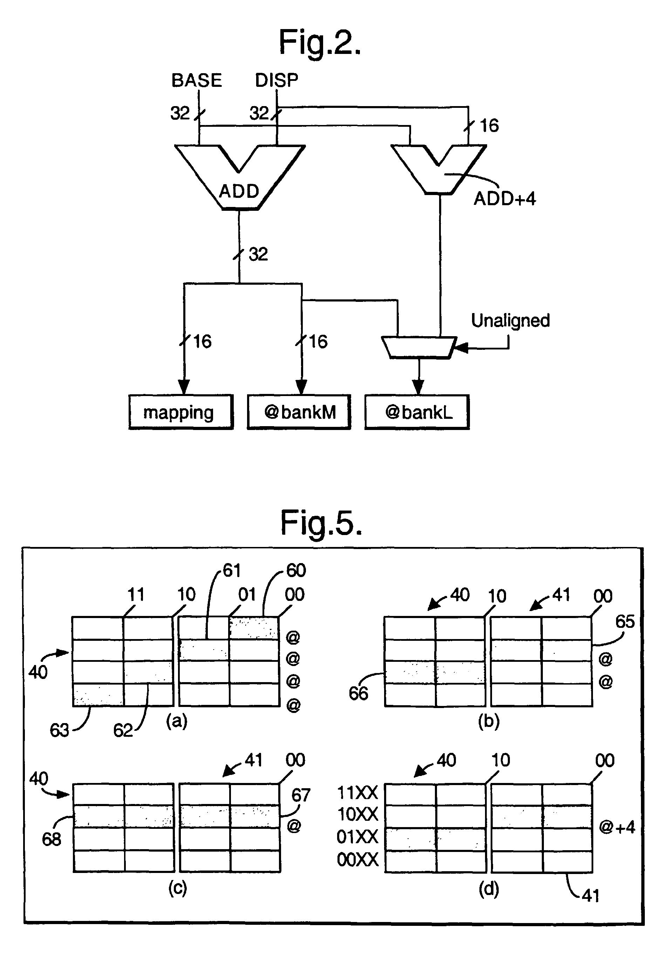

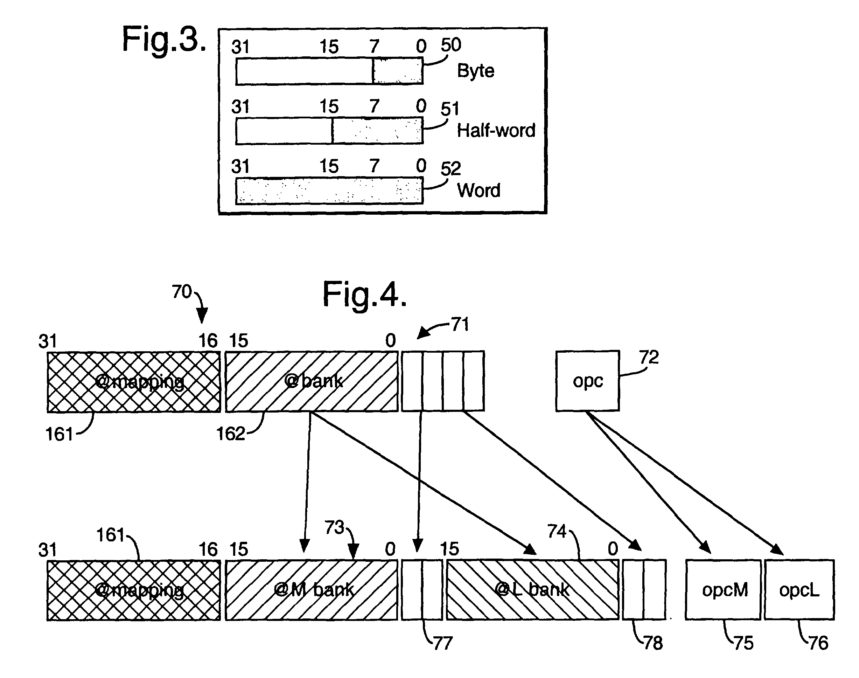

The address controller 32 of the address unit 16 is shown in more detail in Figure 2 but will be described in more detail later. Firstly, the system of data storage in the regions 43 and 45 of the X and Y memories 34 and 35 will be described in more detail. Data is stored in the memory in bit sequences forming words, each word consisting of a multiple number of 8 bit sequences or bytes. In this particular example the wordlength used is 32 bits but other examples may consist of 16 bits or 64 bits or any other multiple number of bytes for each word. The present example using 32 bits in each word is shown in Figure 3. Each word boundary in the memory is designated by a respective memory address and the word boundary commences with a designation of bit 0. In Figure 3 the example 50 indicates a single byte beginning at a word boundary 0 and extending to bit position 7. Example 51 illustrates a half word of data located adjacent a word boundary and the half word extends between bits 0 and 15. Example 52 comprises a whole word beginning at a word boundary and extends from bit 0 to bit 31. Example 52 does form an aligned word in that the entire word extends for 32 bits from a single word boundary.

The present example does however permit ready access to an unaligned word. That is a word consisting of two half words which are not located at a single word boundary. Furthermore it permits access to such an unaligned word in a single memory access cycle.

To achieve effective unaligned word access, the X memory 34 and the Y memory 35 are each divided into the two banks 40 and 41. Each bank is arranged to hold only a half word of data at each addressed location. Figure 5 shows four different memory access operations with each pair of memory banks 40 and 41. In diagram (a) four addressable rows are shown for each memory bank each row having a distinctive effective address. Each memory bank provides two bytes of memory capacity in each row. To achieve a single byte access, the address circuitry 42 and 44 of the two memory banks must be provided with the same word address thereby identifying the required row of memory together with the appropriate byte enable signals to select the required byte from the two memory banks. In the case of diagram (a) in Figure 5 byte 60 can be selected by addressing the top row of memory and providing a byte enable signal solely in the 00 byte position of bank 41 and no byte enable signals for the other three byte positions. Similarly bytes 61, 62 or 63 can be selected by addressing the correct word boundary and providing the required single byte enable signal for that word so that the single byte location is accessed. Each of those bytes would be accessed by a separate access cycle so that four successive access cycles would be needed to access the four separate bytes shown in diagram (a). In diagram (b) two half words are shown each occupying two adjacent byte locations. Half word 65 is located in the L bank 41 whereas half word 66 is located in the M bank 40. They are located in positions relating to different word boundaries and they may be accessed in two successive cycles. The first cycle will access the word boundary containing half word 65 and the byte enable signals will be set for the two bytes in bank 41 but not set for memory bank 40. In the next memory access cycle the word boundary address is that containing the half word 66 and the byte enable signals are set for memory bank 40 but not set for memory bank 41. In this way, each memory access cycle accesses the required half word. For accessing a normally aligned word, the operation is carried out as shown in diagram (c). The aligned word is formed by two bytes 67 in memory bank 41 and two bytes 68 in memory bank 40. These bytes are however aligned in relation to the same word boundary.

Consequently a single memory access cycle will address the required word boundary with all four byte enable signals being set to access the full aligned word of the four bytes.

The present example does however enable the access in a single access cycle of two half words that are not aligned at the same word boundary as shown in diagram (d) of Figure 5. To achieve this, the address controller 32 includes the apparatus shown in Figure 2 and operates as illustrated in Figure 4. The address unit 16 generates an effective address 70 which may be represented as shown in Figure 4 together with four byte enable signals 71 and an OP code signal 72. The effective address is represented as a 32 bit address which is divided into one half represented by the least significant bits 0-15 which are used to identify address within the local memory 20 and the other half formed by the most significant bit 16-31 provide a mapping indication to indicate where within the memory map used by the system the memory is located. In this way the most significant bits can indicate whether the effective address relates to the local memory 20 or some other memory system including the system memory 30. The memory interface 31 arbitrates between accesses to the system memory and the local memory according to the most significant bits. The address controller 32 splits the least significant bits of the effective address into two address signals 73 and 74. These signals are identical and are supplied to the interface 31 which, in the case of a local memory access, supplies those signals to the respective address circuitry 42 and 44 for the M bank 40 and L bank 41 of the local memory. The OP code signal 72 is split to form two identical OP code signals 75 and 76 which are supplied to the M bank 40 and L bank 41 respectively. The four byte enable signals 71 are split to provide two byte enable signals 77 to the M bank 40 and two byte enable signals 78 to the L bank 41. These signals 73 and 74 are used to address a word boundary or row as previously described in relation to Figure 5 and the byte enable signals 77 and 78 enable the selection of access to the required byte positions as previously described with reference to Figure 5. The OP code signals 75 and 76 enable the required operation such as read or write to be carried out as a result of the memory access.

The apparatus of Figure 2 receives on line 80 a 32 bit address indicating a base pointer to a memory location. To create an effective address for a memory access, a 32 bit displacement value is provided on line 81 which is added in a 32 bit adder 82 to form on line 83 an effective address represented by the bit sequence 70 of Figure 4. The least significant 16 bits of the signals provided on lines 80 and 81 are supplied separately on lines 84 and 85 respectively to a 16 bit adder 86. The adder 86, in addition to adding together its two 16 bit inputs adds a further offset value of 4. In this way the output of adder 86 is provided on line 87 in the form of a signal which represents the least significant 16 bits of the effective address on line 83 together with an offset of 4. The effective address on line 83 is split as previously described with reference to Figure 4 so that the most significant 16 bits are provided on line 89 to indicate mapping 90 to identify the correct memory region to be used for the access operation. The least significant bits are provided on line 91 and supplied simultaneously (a) as an output to the interface 31 which may form a direct input 92 to the address circuitry 42 of the M bank memory 40 and (b) as an input 93 to a multiplexer 94. The multiplexer 94 also receives signal 87 representing the address provided by line 93 but incorporating an offset of 4. Multiplexer 94 has a control input 95 which is actuated by the address controller 32 if the memory access is required to access in a single memory access cycle an unaligned word in the local memory 20. The output of multiplexer 94 is supplied to the interface 31 which may be used as an input 96 to the L bank 41 of the local memory 20. When an aligned word access is required of the type shown in Figure 5(c) the multiplexer 94 selects the signal input 93 supplied to the L bank 41 so that both the M bank 40 and L bank 41 receive the same address identifying the same word boundary. When however it is required to access an unaligned word as shown in Figure 5(d) the multiplexer is activated to select the signal from line 87 to supply to the L bank 41. In this way the address circuitry of the respective M bank 40 and L bank 41 receive simultaneously for the same access cycle, addresses indicating word boundaries offset by four bytes from each other. Referring therefore to Figure 5(d) the address which is input at 92 to M bank 40 will address word boundary identified by the address 01XX and the byte enable signals supplied to the M bank 40 will enable access to both bytes at that address location. At the same time, the address input at 96 to the L bank 41 will address the row identified by word boundary address 10XX. Two byte enable signals will also be supplied to the L bank 41 so that both bytes in that bank at the word address 10XX are accessed.

In this way an unaligned word is accessed by a single access cycle.

Furthermore, it will be seen that the appropriate offset address for the L bank 41 has been simply calculated by use of the 16 bit adder 86. It has not been necessary to use an adder having the full number of bits used for addressing the memory access operations. The 32 bit memory address has been split prior to adding the offset so that the adder used to provide the offset of 4 operates solely on the least significant bits which are used to identify the word boundary locations within the required memory regions.

The example above reduces delays in operation by reducing the number of memory access operations required and it provides improved use of memory space.

The invention is not limited to the details of the foregoing example.

## Claims

1. A computer system comprising instruction supply circuitry, a plurality of parallel instruction execution pipelines, a read and write memory, a memory addressing circuitry for addressing said memory as a result of instruction execution in said pipelines, wherein said memory is arranged to hold data in addressable words each comprising a plurality of bytes forming two half words, said memory addressing circuitry being operable to provide successively a plurality of word addresses and said memory comprising two memory banks each having respective access circuitry for the same word addresses and a memory capacity of half a word at each word address, said memory addressing circuitry having address output circuitry to provide an address to both memory banks simultaneously and adder circuitry to add to a word address for one of the banks a number equal to the number of bytes in a word, the address output circuitry thereby being selectively operable to access in a single access cycle two unaligned half words from respective memory banks at adjacent word locations in the two memory banks.

2. A computer system according to claim 1 in which said memory addressing circuitry is arranged to separate each word address into a first set of bits identifying a memory region provided by said two memory banks and a second set of bits identifying a memory address within said memory banks, said adder being arranged to receive said second set of bits and selectively add said number to said second set of bits.

3. A computer system according to claim 2 in which said second set of bits comprise the least significant half of the bits of the memory address.

4. A computer system according to any one of the preceding claims in which said one of said memory banks is connected to a multiplexer having two inputs, one input being an output from said adder and a second input being the address supplied to the other memory bank, whereby selective operation of the multiplexer permits access to an aligned word or an unaligned word in the two memory banks.

5. A computer system according to any one of the preceding claims in which said memory addressing circuitry is operable to provide byte enable signals to indicate which bytes at each word address are to be accessed, and said access circuitry of each memory bank is arranged to receive said byte enable signals to access selected bytes at each word location addressed in the memory banks.

6. A computer system according to any one of the preceding claims including timing circuitry to control access to each memory bank simultaneously in successive access cycles, said memory addressing circuitry being operable to access either aligned or unaligned words in the same access cycle.

7. A method of accessing memory in a computer system having a memory arranged to hold data in addressable words each comprising a plurality of bytes forming two half words, said method comprising dividing the memory into two memory banks each having respective access circuitry for the same word addresses and a memory capacity of half a word at each word address, generating a single address for use in addressing both memory banks simultaneously, adding to said address a number equal to the number of bytes in a word to form an incremented address and selectively supplying said address to one memory bank and said incremented address to the other memory bank thereby to access in the same access cycle half words from respective memory banks forming an unaligned word.

8. A method according to claim 7 in which said address comprises only the least significant bits of a full word address, said bits being sufficient to identify the memory region provided by said memory banks and said number is added only to said least significant bits.

9. A method according to claim 7 or claim 8 in which byte enable signals are supplied to each memory bank to access selected bytes at each word location addressed in the memory bank.
